(19) Europäisches Patentamt / European Patent Office / Office européen des brevets

(11) **EP 2 762 444 A1**

(12) **EUROPEAN PATENT APPLICATION**
published in accordance with Art. 153(4) EPC

(43) Date of publication:
06.08.2014 Bulletin 2014/32

(21) Application number: **12836552.5**

(22) Date of filing: **25.09.2012**

(51) Int Cl.:
*C01B 19/00* (2006.01)        *B82Y 40/00* (2011.01)
*H01L 31/04* (2014.01)

(86) International application number:
**PCT/JP2012/074461**

(87) International publication number:
**WO 2013/047461 (04.04.2013 Gazette 2013/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **30.09.2011 JP 2011217028**
**27.02.2012 JP 2012040060**

(71) Applicants:
• **Toppan Printing Co., Ltd.**
**Tokyo 110-0016 (JP)**

• **Tokyo Institute of Technology**
**Tokyo 152-8550 (JP)**

(72) Inventors:
• **ZHANG, Yiwen**
**Tokyo 110-0016 (JP)**
• **YAMADA, Akira**
**Tokyo 152-8550 (JP)**

(74) Representative: **TBK**
**Bavariaring 4-6**
**80336 München (DE)**

(54) **INK FOR FORMING COMPOUND SEMICONDUCTOR THIN FILM AND METHOD FOR PRODUCING SAME**

(57)    A method for producing a nanoparticle for forming a CZTS compound semiconductor thin film is provided which includes the step of reacting a solution including a metal salt or a metal complex with a solution including a chalcogenide salt to produce a CZTS compound nanoparticle. A CZTS compound semiconductor thin film is formed by coating or printing the nanoparticle for forming the CZTS compound semiconductor thin film, and subjecting it to a heat treatment. A solar cell including the CZTS compound semiconductor thin film as the light-absorbing layer (103) is provided.

FIG. 1

EP 2 762 444 A1

## Description

Technical Field

The present invention relates to a method for producing a nanoparticle, an ink for forming a compound semiconductor thin film including the nanoparticle and a production method thereof, a compound semiconductor thin film formed using the ink, a solar cell comprising the compound semiconductor thin film, and a method for producing the solar cell.

Background Art

A solar cell is a device which converts light energy into electrical energy using a photovoltaic effect and has recently attracted attention from the viewpoints of global warming prevention and as a substitute for depleting resources. As a semiconductor used in the solar cell, monocrystal Si, polycrystal Si, amorphous Si, CdTe, $CuIn_{1-x}Ga_xSe_2$ (CIGS), $Cu_2ZnSn(S,Se)_4$ (CZTS), GaAs, InP, and the like are known. Of these, $Cu_2ZnSn(S,Se)_4$ (CZTS) is characterized by having a high optical absorption coefficient, a band-gap energy (1.4 to 1.5eV) suitable for the solar cell, low environmental burden, and including no rare elements. It is expected to be used for future solar cells used as a substitute product of a CIS ($CuInSe_2$) thin film solar cell or a CdTe thin film solar cell, which is now commercialized.

Various methods for producing a CZTS compound semiconductor have hitherto been proposed. For example, Patent Literature 1 proposes a method for producing a CZTS thin film including producing a CZTS precursor from Cu, ZnS and SnS as starting materials on a Mo-coated SLG substrate using a sputtering method, and heating the resulting film at 580°C for 2 hours in a 20% hydrogen sulfide atmosphere.

According to the method, however, sulfur is selectively evaporated during the sputtering due to the influence of plasma, because of a low melting temperature of sulfur or SnS, thus resulting in the difficulty of obtaining a CZTS thin film having a desired composition ratio. In addition, using a vacuum process such as sputtering leads to a high capital investment, a high electric power consumption, and a relatively high cost.

In order to improve the problems described above, Patent Literature 2 proposes a method in which $Cu_2S$, Zn, SnSe, S and Se are dissolved in a hydrazine solvent, and the solution is subjected to thermal annealing to produce a CZTS compound semiconductor. According to this method, a phenomenon in which sulfur is selectively evaporated during the sputtering does not occur, and the capital investment can be reduced and the low cost can be realized, because of the use of a non-vacuum process.

According to this method, however, special attention is needed for handling, because hydrazine, which is a toxic and highly explosive solvent, is used, and thus the method has a problem of high environmental burden. For that reason, it is difficult to use this method in mass production on an industrial scale.

Citation List

Patent Literatures

Patent Literature 1: Jpn. Pat. Appln. KOKAI Publication No. 2009-26891
Patent Literature 2: US 2011/0097496

Summary of Invention

Technical Problem

The present invention has been made under the circumstances described above, and the object of the invention is to provide a method for producing nanoparticles for forming a CZTS compound semiconductor thin film, capable of producing a low cost solar cell, an ink for forming a compound semiconductor thin film including the nanoparticles and a production method thereof, a compound semiconductor thin film formed using the ink, a solar cell comprising the CZTS compound semiconductor thin film, and a method for producing the solar cell.

Solution to Problem

In order to solve the problems described above, a first aspect of the present invention provides a method for producing a nanoparticle for forming a CZTS compound semiconductor thin film including the step of reacting a solution including a metal salt or a metal complex with a solution including a chalcogenide salt to produce a CZTS compound nanoparticle.

In the method for producing such a nanoparticle for forming a CZTS compound semiconductor thin film, the temperature at which the nanoparticles are produced can be controlled to a temperature of -67°C or higher and 25°C or lower, and more preferably, the temperature can be controlled to -5°C or higher and 5°C or lower.

As the metal salt, a salt including a halogen atom can be used.

As the metal salt, a metal iodide salt can be used.

As the metal iodide salt, at least one selected from the group consisting of CuI, $ZnI_2$, and $SnI_2$ can be used.

As the chalcogenide salt, at least one selected from the group consisting of $Na_2Se$ and $Na_2S$ can be used.

The nanoparticle can be a nanoparticle including a compound represented by $Cu_{2-x}Zn_{1+y}SnS_zSe_{4-z}$ ($0 \leq x \leq 1$, $0 \leq y \leq 1$, $0 \leq z \leq 4$).

The nanoparticle described above can be at least one selected from the group consisting of a compound represented by $Cu_{2-x}S_ySe_{2-y}$ ($0 \leq x \leq 1$, $0 \leq y \leq 2$), a compound represented by $Zn_{2-x}S_ySe_{2-y}$ ($0 \leq x \leq 1$, $0 \leq y \leq 2$), and a compound represented by $Sn_{2-x}S_ySe_{2-y}$ ($0 \leq x \leq 1$, $0 \leq y \leq 2$).

As the nanoparticle, a nanoparticle having a particle diameter of 1 to 200 nm can be used.

As the nanoparticle, a nanoparticle having a composition ratio Cu/(Zn + Sn) of elements forming the compound of 0.6 to 0.99 can be used.

A second aspect of the present invention provides a nanoparticle for forming a CZTS compound semiconductor thin film which is produced in accordance with the method described above.

A third aspect of the present invention provides an ink for forming a CZTS compound semiconductor thin film including the nanoparticle according to the second aspect of the present invention dispersed in an organic solvent.

A fourth aspect of the present invention provides a method for producing an ink for forming a CZTS compound semiconductor thin film including the step of dispersing the nanoparticle according to the second aspect of the present invention in an organic solvent.

As the organic solvent, at least one selected from the group consisting of methanol and pyridine can be used.

At least one selected from the group consisting of a Se compound and a S compound can be added to the ink as a binder.

Thiourea can be added to the ink as a binder.

A particle of at least one selected from the group consisting of a particle including a Se element and a particle including a S element can be added to the ink as a binder.

A particle of at least one selected from the group consisting of a Se particle and a S particle can be added to the ink as a binder.

As the nanoparticle added to the ink, a particle having a particle diameter of 1 to 200 nm can be used.

A fifth aspect of the present invention provides a CZTS compound semiconductor thin film formed by coating or printing the ink for forming a CZTS compound semiconductor thin film according to the third aspect of the present invention, and subjecting it to a heat treatment.

A sixth aspect of the present invention provides a solar cell including a light-absorbing layer, which includes a CZTS compound semiconductor thin film formed by coating or printing the ink for forming a CZTS compound semiconductor thin film according to the third aspect of the present invention on an electrode formed on a substrate and subjecting it to a heat treatment.

A seventh aspect of the present invention provides a method for producing a solar cell including the steps of coating or printing the ink for forming a CZTS compound semiconductor thin film according to the third aspect of the present invention on an electrode formed on a substrate to form a coating film of the CZTS compound semiconductor, and subjecting the coating film of the CZTS compound semiconductor to a heat treatment to form a light-absorbing layer including the CZTS compound semiconductor thin film.

The heat treatment temperature of the coating film of the CZTS compound semiconductor can be controlled at 460°C to 650°C.

Advantageous Effects of Invention

The present invention provides a method for producing a nanoparticle for forming a CZTS compound semiconductor thin film, an ink for forming a compound semiconductor thin film including the nanoparticle and a production method thereof, a compound semiconductor thin film formed using the ink, a solar cell comprising the CZTS compound semiconductor thin film, and a production method of the solar cell, which are low in cost, have low environmental burden, and are capable of being used for a mass production on an industrial scale.

Brief Description of Drawings

FIG. 1 is a vertical cross-sectional side view schematically showing a solar cell according to an embodiment of the present invention.
FIG. 2 is a characteristic diagram showing in-situ XRD measurement results, used for obtaining heat treatment temperatures of a coating film of an ink for forming a semiconductor thin film according to an embodiment of the present invention.

Mode for Carrying out the Invention Embodiments of the present invention are explained below, referring to figures.

The CZTS compound used in the instant specification refers to a compound semiconductor having a basic structure of $Cu_2ZnSn(S,Se)_4$ wherein In in a compound CuInSe (CIS) is substituted by Zn or Sn, and Se is substituted by S.

First, the first embodiment of the present invention is explained.

The method for producing nanoparticles according to the first embodiment of the present invention is characterized by reacting a solution including a metal salt or a metal complex with a solution including a chalcogenide salt to produce a nanoparticle for forming a CZTS compound semiconductor thin film.

As the metal salt or the metal complex, CuI, $CuSO_4$, $Cu(NO_3)_2$, $Cu(CH_3COO)_2$, $ZnI_2$, $ZnSO_4$, $Zn(NO_3)_2$, $Zn(CH_3COO)_2$, $SnI_2$, $SnSO_4$, $Sn(CH_3COO)_2$, and the like, can be used.

As the metal salt, a salt including a halogen atom is preferable. The metal salt including the halogen atom may include, for example, $CuCl_2$, $CuBr$, $CuI$, $ZnCl_2$, $ZnBr_2$, $ZnI_2$, $SnCl_2$, $SnBr_2$, $SnI$, and the like. At least one selected from the group consisting of $CuI$, $ZnI_2$ and $SnI_2$ is particularly preferable.

As the chalcogenide salt, $K_2Se$, $Na_2Se$, $K_2S$, $Na_2S$, and the like can be used. A mixture thereof can also be used.

When $Na_2Se$ or $Na_2S$ is used as the chalcogenide salt, $NaI$, which is a by-product generated by a reaction thereof with a metal iodide, can be, preferably, easily separated from the nanoparticles by centrifugation, or the like, because of their high solubility in an organic solvent.

It is desirable to produce the nanoparticles at a temperature of -67°C or higher and 25°C or lower. When the temperature is higher than 25°C, the reaction rate becomes too high, and it tends to be difficult to control the particle diameter. When the temperature is lower than-67°C, the reaction rate is too slow, and the production time tends to be prolonged. More preferably temperatures are -5°C or higher and 5°C or lower.

The nanoparticle, which is the reaction product of the solution including the metal salt or metal complex with the solution including the chalcogenide salt, can be, for example, a particle of a compound represented by $Cu_{2-x}Zn_{1+y}SnS_zSe_{4-z}$ ($0 \leq x \leq 1$, $0 \leq y \leq 1$, $0 \leq z \leq 4$).

The nanoparticles can also be a mixture of at least one selected from the group consisting of particles of a compound represented by $Cu_{2-x}S_ySe_{2-y}$ ($0 \leq x \leq 1$, $0 \leq y \leq 2$), a compound represented by $Zn_{2-x}S_ySe_{2-y}$ ($0 \leq x \leq 1$, $0 \leq y \leq 2$), and a compound represented by $Sn_{2-x}S_ySe_{2-y}$ ($0 \leq x < 1$, $0 \leq y \leq 2$). A compound including Cu (IB group), Zn (IIB group), Sn (IVB group), S (VIB group) and/or Se (VIB group) is generally referred to as a CZTS compound.

The nanoparticles produced in accordance with the method of the present invention have preferably an average particle diameter of 1 nm or more and 200 nm or less. When the nanoparticles have an average particle diameter of more than 200 nm, gaps are easily formed in the CZTS compound semiconductor thin film during the step in which the CZTS compound semiconductor thin film is subjected to the heat treatment, the surface roughness becomes high, and it tends to reduce a photoelectric conversion efficiency.

On the other hand, when the nanoparticles have an average particle diameter of less than 1 nm, the particles are easily aggregated, and thus it is difficult to prepare an ink. The nanoparticles have more preferably an average particle diameter of 5 nm or more and 100 nm or less. The average particle diameter of the nanoparticles is an average value of the shortest diameters of metal nanoparticles observed using an SEM (scanning electron microscope) or TEM (transmission electron microscope).

A composition ratio of the embodiments of the compound or the mixture forming the nanoparticle, Cu/(Zn + Sn), is preferably from 0.6 to 0.99, more preferably from 0.8 to 0.9. When the ratio Cu/(Zn + Sn) is 1 or more, it is easy to generate a semimetal, CuS, and the resulting CZTS thin film has too low a resistance, thus resulting in a possibility of reduced photoelectric conversion efficiency. When the ratio Cu/(Zn + Sn) is less than 0.6, the semiconductor has a low carrier concentration, and the photoelectric conversion efficiency may possibly be reduced.

The nanoparticles, which are obtained in accordance with the present embodiment as explained above, are dispersed in an organic solvent, whereby the ink for forming the CZTS compound semiconductor thin film can be produced.

The organic solvent is not particularly limited, and, for example, alcohols, ethers, esters, aliphatic hydrocarbons, alicyclic hydrocarbons, aromatic hydrocarbons and the like can be used. Preferable organic solvents may include alcohols having less than 10 carbon atoms such as methanol, ethanol and butanol, diethyl ether, pentane, hexane, cyclohexane and toluene, and particularly preferable organic solvents may include methanol, pyridine, toluene and hexane.

In order to efficiently disperse the nanoparticles in the organic solvent, a dispersant can be added to the ink for forming the CZTS compound semiconductor thin film. The dispersant may include thiols, selenols, alcohols having 10 or more carbon atoms, and the like.

In order to obtain a dense semiconductor thin film, it is also possible to add a binder to the ink for forming the CZTS compound semiconductor thin film. As the binder, Se particles, S particles, a Se compound, a S compound, and the like can be used. Thiourea may also be added thereto as the binder. A solid concentration in the organic solvent is not particularly limited, and it is generally from 1 to 20% by weight.

The particles added as the binder can have a particle diameter of 1 to 200 nm. It is preferable that the particle diameter of the particles added as the binder is smaller than the particle diameter of the nanoparticles.

Next, an explanation is made for a CZTS compound semiconductor thin film according to the second embodiment of the present invention.

The CZTS compound semiconductor thin film according to the second embodiment of the present invention is formed by coating or printing the ink for forming the CZTS compound semiconductor thin film described above on a substrate, drying it to remove the organic solvent therefrom, and subjecting the resulting film to a heat treatment.

The coating method may include a doctor method, a spin coating method, a slit coating method, a spray method, and the like. The printing method may include a gravure printing method, a screen printing method, a reverse offset printing method, a relief printing method, and the like.

The coating film formed by the coating or printing has preferably such a thickness is that a thickness of the CZTS compound semiconductor thin film is from 0.5

to 10 μm such as about 2 μm after the drying or the heat treatment. The heat treatment can be performed by annealing in a heating furnace or rapid thermal annealing (RTA).

The heat treatment temperature is desirably 350°C or higher, because the temperature is required to be a temperature necessary for the crystallization of the CZTS compound semiconductor. When a glass substrate is used as the substrate, the heat treatment temperature is desirably 650°C or lower, particularly 550°C or lower, because it is necessary that the glass substrate can withstand that temperature. The range thereof is preferably from 450°C to 650°C, more preferably from 450°C to 550°C.

According to experiments performed by the present inventors, it is confirmed that the crystallization of the CZTS compound semiconductor is rapidly advanced at the heat treatment temperature of 460 to 500°C. The heat treatment temperature of the coating film of the ink for forming the CZTS compound semiconductor thin film is, accordingly, most preferably from 460 to 500°C.

The heat treatment can be performed in at least one atmosphere selected from the group consisting of a nitrogen atmosphere, an argon atmosphere, a forming gas atmosphere, a hydrogen atmosphere, a Se gas atmosphere, a S gas atmosphere, an $H_2Se$ gas atmosphere, and an $H_2S$ gas atmosphere. When the treatment is performed in an atmosphere of both Se gas and S gas, a band structure can be controlled. In order to form a grade band, preferably the film is first treated in an atmosphere including the Se element, and then an atmosphere including the S element.

The experiments performed by the present inventors and the results thereof are shown below.

An ink including Cu-Zn-Sn-Se-S nanoparticles is coated on a Pt plate as a substrate, the heat treatment is performed varying the heat treatment temperature within a range of 400°C to 600°C, and the analysis thereof is performed using an in-situ XRD. The Cu-Zn-Sn-Se-S coating film used has a composition ratio described below.

$$Cu/(Zn + Sn) = 0.74$$

$$Zn/Sn = 1.3$$

$$Cu/Sn = 1.7$$

Measurement conditions in the in-situ XRD are as follows:

Measurement Atmosphere: Nitrogen Atmosphere
Measurement Range: 25 to 35 deg
Rate of Temperature Rise: 10°C/minute
Scanning Speed: 10 deg/minute

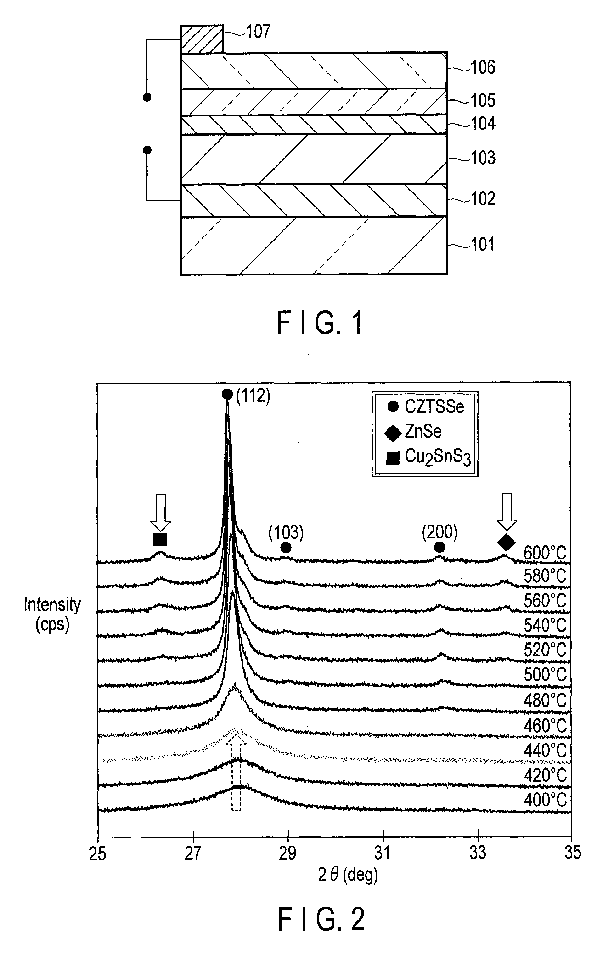

The XRD scanning is started 2 minutes after the temperature reaches a predetermined temperature.
The measurement results are shown in FIG. 2.
From FIG. 2, it can be seen that the crystallization of the CZTS compound is rapidly advanced within a narrow temperature range of 460 to 500°C.
A solar cell according to the third embodiment of the present invention is explained below.
FIG. 1 is a vertical cross-sectional side view showing schematically the solar cell according to the third embodiment of the present invention. In the solar cell shown in FIG. 1, a back electrode 102 is formed on a substrate 101. As the substrate 101, a soda lime glass, a metal plate, a plastic film, and the like can be used.
As the back electrode 102, a metal such as molybdenum (Mo), nickel (Ni) or copper (Cu) can be used. A known carbon electrode such as carbon and graphene can also be used. Further, a known transparent conductive film such as ITO or ZnO can also be used.
The CZTS compound semiconductor thin film, according to the second embodiment, is formed on the back electrode 102, as a light-absorbing layer 103. The light-absorbing layer 103 is, accordingly, formed by coating the ink for forming the CZTS compound semiconductor thin film on the back electrode 102, drying it, and subjecting the resulting film to a heat treatment. This light-absorbing layer performs photoelectric conversion.
A buffer layer 104, an i-layer 105, and an n-layer 106 are sequentially formed on the light-absorbing layer 103. For the buffer layer 104, known CdS, Zn(S, O, OH) and $In_2S_3$ can be used. For the i-layer 105, a known metal oxide such as ZnO can be used. For the n-layer 106, known ZnO to which Al, Ga or B is added can be used.
Subsequently, a surface electrode 107 is formed on the n-layer 106, thereby completing a solar cell. As the surface electrode 107, a known metal such as Al or Ag can be used. A known carbon electrode such as carbon or graphene can also be used. Further a known transparent conductive film such as ITO or ZnO can also be used.
Although it is not illustrated, an antireflection film, which serves to suppress light reflection and allows much more light to be absorbed by the light-absorbing layer, can also be formed on the n-layer 106. A material for the antireflection film is not particularly limited, and for example, magnesium fluoride ($MgF_2$) can be used. The antireflection film has an appropriate thickness of about 100 nm.
In the solar cell having such a structure, according to the third embodiment, the ink for forming the CZTS compound semiconductor thin film in which the nanoparticles are dispersed is coated or printed, then dried, and the resulting film is subjected to a heat treatment, thereby forming the light-absorbing layer, and accordingly the area thereof can be easily made larger compared to the case in which the method shown in Patent Literature 1 is employed, and it is possible to reduce the cost. In addition, compared to the method shown in Patent Literature 2, in which hydrazine is used as the solvent, the environmental burden can be further reduced, and the mass production in an industrial scale can be more easily realized.

<Examples>

The present invention is explained in more detailed below based on Examples, but the invention is not limited thereto.

(Example 1)

(Production of Cu-Zn-Sn-Se-S nanoparticles)

A solution in which CuI, $ZnI_2$, and $SnI_2$ were dissolved in pyridine was mixed with a solution in which $Na_2Se$ and $Na_2S$ were dissolved in methanol so that a ratio of Cu/Zn/Sn/Se/S was set to 2.5/1.5/1.25/2/2. This mixture was reacted at 0°C in an inert gas atmosphere to produce Cu-Zn-Sn-Se-S nanoparticles. As a result of observation using scanning microscopy, the obtained Cu-Zn-Sn-Se-S nanoparticles had an average particle diameter of 80 nm. The reaction solution was filtered, washed with methanol, and the obtained Cu-Zn-Sn-Se-S nanoparticles were dispersed in a mixed liquid of pyridine and methanol.

(Preparation of Ink)

To the thus obtained dispersion of the Cu-Zn-Sn-Se-S nanoparticles was added thiourea as a binder so that a weight ratio of the Cu-Zn-Sn-Se-S nanoparticles to thiourea was set to 3 : 2. Methanol was added thereto so that the resulting mixture had a solid content of 5% by weight to prepare an ink.
Next, a solar cell having the structure shown in FIG. 1 was produced as follows:

(Formation of Back Electrode 102)

A back electrode 102 made of an Mo layer was formed on a soda lime glass plate 101 using a sputtering method.

(Formation of Light-Absorbing Layer 103)

The back electrode 102 was coated with the ink for forming the CZTS compound semiconductor thin film obtained as above in accordance with a doctor method, a solvent was evaporated therefrom in an oven having a temperature of 250°C, and then the resulting film was heated at 500°C for 30 minutes to form a light-absorbing layer 103 of CZTSSe having a thickness of 2 $\mu$m.

(Formation of Buffer Layer 104)

The structure in which the light-absorbing layer 103 was formed was immersed in a mixed aqueous solution including cadmium sulfate ($CdSO_4$), thiourea ($NH_2CSNH_2$) and aqueous ammonia ($NH_4OH$) in molar concentrations of 0.0015 M, 0.0075 M and 1.5 M, respectively, having a temperature of 70°C, thereby forming a buffer layer 104 made of CdS having a thickness of 50 nm on the light-absorbing layer 103.

(Formation of i-Layer 105)

An i-layer 105 made of ZnO having a thickness of 50 nm was formed on the buffer layer 104 from diethyl zinc and water as starting materials using an MOCVD method.

(Formation of n-Layer 106)

An n-layer 106 made of ZnO:B having a thickness of 1 $\mu$m was formed on the i-layer 105 from diethyl zinc, water and diborane as starting materials using an MOCVD method.

(Formation of Surface Electrode 107)

A surface electrode 107 made of Al having a thickness of 0.3$\mu$m was formed on the n-layer 106 using a vapor deposition method.
As described above, a CZTS solar cell was completed.

(Example 2)

(Production of Cu-Zn-Sn-Se nanoparticles)

A solution in which CuI, $ZnI_2$ and $SnI_2$ were dissolved in pyridine was mixed with a solution in which $Na_2Se$ was dissolved in methanol so that a ratio of Cu/Zn/Sn/Se was set to 2/1.5/1.2/3.7. This mixture was reacted at 0°C in an inert gas atmosphere to produce Cu-Zn-Sn-Se nanoparticles. As a result of observation using scanning microscopy, the obtained Cu-Zn-Sn-Se nanoparticles had an average particle diameter of 50 nm. The reaction solution was filtered, washed with methanol, and the obtained Cu-Zn-Sn-Se nanoparticles were dispersed in a mixed liquid of pyridine and methanol.

(Preparation of Ink)

To the thus obtained dispersion of the Cu-Zn-Sn-Se nanoparticles was added thiourea as a binder so that a weight ratio of Cu-Zn-Sn-Se nanoparticles to thiourea was set to 3 : 2. Methanol was added thereto so that the resulting mixture had a solid content of 5% by weight to prepare an ink.

Next, a solar cell was produced in the same process as in Example 1.

Evaluation of the solar cells produced in Examples 1 and 2 were performed using a standard solar radiation simulator (light intensity: 100 mW/cm$^2$ and air mass: 1.5). As a result, the photoelectric conversion efficiency was a high value, such as 3.1% or 2.5%. This shows that the CZTS solar cells having excellent properties were obtained at a low cost by the production method which can be easily operated and involves low environmental burden.

Reference Signs List

101 ... Glass substrate, 102 ... Back electrode 103 ... Light-absorbing layer, 104 ... Buffer layer 105 ... i-layer, 106 ... n-layer, 107 ... Surface electrode

**Claims**

1. A method for producing a nanoparticle for forming a CZTS compound semiconductor thin film, the method comprising:

    reacting a solution including a metal salt or a metal complex with a solution including a chalcogenide salt to produce a CZTS compound nanoparticle.

2. The method for producing a nanoparticle for forming a CZTS compound semiconductor thin film according to claim 1, wherein the nanoparticle is produced at a temperature of -67°C or higher and 25°C or lower.

3. The method for producing a nanoparticle for forming a CZTS compound semiconductor thin film according to claim 1 or 2, wherein the metal salt comprises a halogen atom.

4. The method for producing a nanoparticle for forming a CZTS compound semiconductor thin film according to any of claims 1 to 3, wherein the metal salt is a metal iodide salt.

5. The method for producing a nanoparticle for forming a CZTS compound semiconductor thin film according to claim 4, wherein the metal iodide salt is at least one selected from the group consisting of CuI, ZnI$_2$, and SnI$_2$.

6. The method for producing a nanoparticle for forming a CZTS compound semiconductor thin film according to any of claims 1 to 3, wherein the chalcogenide salt is at least one selected from the group consisting of Na$_2$Se and Na$_2$S.

7. The method for producing a nanoparticle for forming a CZTS compound semiconductor thin film according to any of claims 1 to 3, wherein the nanoparticle comprises a compound represented by Cu$_{2-x}$Zn$_{1+y}$SnS$_z$Se$_{4-z}$ ($0 \leq x \leq 1$, $0 \leq y \leq 1$, $0 \leq z \leq 4$).

8. The method for producing a nanoparticle for forming a CZTS compound semiconductor thin film according to any of claims 1 to 3, wherein the nanoparticle is at least one selected from the group consisting of a compound represented by Cu$_{2-x}$S$_y$Se$_{2-y}$ ($0 \leq x \leq 1$, $0 \leq y \leq 2$), a compound represented by Zn$_{2-x}$S$_y$Se$_{2-y}$ ($0 \leq x \leq 1$, $0 \leq y \leq 2$), and a compound represented by Sn$_{2-x}$S$_y$Se$_{2-y}$ ($0 \leq x \leq 1$, $0 \leq y \leq 2$) .

9. The method for producing a nanoparticle for forming a CZTS compound semiconductor thin film according to any of claims 1 to 3, wherein the nanoparticles have a particle diameter of 1 to 200 nm.

10. The method for producing a nanoparticle for forming a CZTS compound semiconductor thin film according to claim 7, wherein a composition ratio Cu/(Zn + Sn) of elements in the compound forming the nanoparticles is from 0.6 to 0.99.

11. A nanoparticle for forming a CZTS compound semiconductor thin film produced by the method according to any of claims 1 to 3.

12. An ink for forming the CZTS compound semiconductor thin film comprising the nanoparticle according to claim 11 dispersed in an organic solvent.

13. A method for producing an ink for forming the CZTS compound semiconductor thin film, the method comprising:

    dispersing the nanoparticle according to claim 11 in an organic solvent.

14. The method for producing an ink for forming the CZTS compound semiconductor thin film according to claim 13, wherein the organic solvent is at least one selected from the group consisting of methanol and pyridine.

15. The method for producing an ink for forming the CZTS compound semiconductor thin film according to claim 13 or 14, further comprising the step of adding at least one selected from the group consisting of a Se compound and a S compound to the ink as a binder.

16. The method for producing an ink for forming the CZTS compound semiconductor thin film according to claim 13 or 14, further comprising the step of adding thiourea to the ink as a binder.

**17.** The method for producing an ink for forming the CZTS compound semiconductor thin film according to claim 13 or 14, further comprising the step of adding a particle of at least one selected from the group consisting of a particle including a Se element and a particle including a S element to the ink as a binder.

**18.** The method for producing an ink for forming the CZTS compound semiconductor thin film according to claim 13 or 14, further comprising the step of adding a particle of at least one selected from the group consisting of Se a particle and a S particle to the ink as a binder.

**19.** The method for producing an ink for forming the CZTS compound semiconductor thin film according to claim 17, wherein the particle added to the ink as the binder have a particle diameter of 1 to 200 nm.

**20.** A CZTS compound semiconductor thin film formed by coating or printing the ink for forming the CZTS compound semiconductor thin film according to claim 12, and subjecting it to a heat treatment.

**21.** A solar cell comprising a light-absorbing layer made of a CZTS compound semiconductor thin film formed by coating or printing the ink for forming the CZTS compound semiconductor thin film according to claim 12 on an electrode formed on a substrate, and subjecting it to a heat treatment.

**22.** A method for producing a solar cell comprising the steps of:

coating or printing the ink for forming the CZTS compound semiconductor thin film according to claim 12 on an electrode formed on a substrate to form a coating film of a CZTS compound semiconductor; and

subjecting the coating film of the CZTS compound semiconductor to a heat treatment to form a light-absorbing layer comprising the CZTS compound semiconductor thin film.

**23.** The method for producing a solar cell according to claim 22, wherein the coating film of the CZTS compound semiconductor is subjected to the heat treatment at a temperature of 450°C to 650°C.

F I G. 1

F I G. 2

## INTERNATIONAL SEARCH REPORT

| International application No. |
| --- |
| PCT/JP2012/074461 |

A.  CLASSIFICATION OF SUBJECT MATTER
*C01B19/00*(2006.01)i, *B82Y40/00*(2011.01)i, *H01L31/04*(2006.01)i

According to International Patent Classification (IPC) or to both national classification and IPC

B.   FIELDS SEARCHED

Minimum documentation searched (classification system followed by classification symbols)
C01B19/00, B82Y40/00, H01L31/04

Documentation searched other than minimum documentation to the extent that such documents are included in the fields searched
| Jitsuyo Shinan Koho | 1922–1996 | Jitsuyo Shinan Toroku Koho | 1996–2012 |
| Kokai Jitsuyo Shinan Koho | 1971–2012 | Toroku Jitsuyo Shinan Koho | 1994–2012 |

Electronic data base consulted during the international search (name of data base and, where practicable, search terms used)
CAplus(STN), REGISTRY(STN)

C.   DOCUMENTS CONSIDERED TO BE RELEVANT

| Category* | Citation of document, with indication, where appropriate, of the relevant passages | Relevant to claim No. |
| --- | --- | --- |
| X<br>Y<br>A | KR 10-2011-0075227 A  (DAEGU GYEONGBUK INSTITUTE OF SCIENCE AND TECHNOLOGY), 06 July 2011 (06.07.2011), paragraphs [0007] to [0012], [0019], [0027] to [0040] (Family: none) | 1,3-14,20-23<br>15-19<br>2 |
| X<br>Y<br>A | WO 2011/016283 A1  (Mitsui Mining & Smelting Co., Ltd.), 10 February 2011 (10.02.2011), paragraphs [0014], [0018] to [0045] (Family: none) | 1-3,6-11<br>12-23<br>4,5 |

| ☒ | Further documents are listed in the continuation of Box C. | ☐ | See patent family annex. |
| --- | --- | --- | --- |

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 20 November, 2012 (20.11.12) | 04 December, 2012 (04.12.12) |

| Name and mailing address of the ISA/ | Authorized officer |
| --- | --- |
| Japanese Patent Office | |
| Facsimile No. | Telephone No. |

Form PCT/ISA/210 (second sheet) (July 2009)

**INTERNATIONAL SEARCH REPORT**

| International application No. |
| --- |
| PCT/JP2012/074461 |

C (Continuation). DOCUMENTS CONSIDERED TO BE RELEVANT

| Category* | Citation of document, with indication, where appropriate, of the relevant passages | Relevant to claim No. |
| --- | --- | --- |
| X<br>Y<br>A | CN 101844797 A (DONGHUA UNIVERSITY),<br>29 September 2010 (29.09.2010),<br>paragraphs [0001], [0005] to [0015], [0021] to [0029]<br>(Family: none) | 1,3,6,7,9,11<br>12-23<br>2,4,5,8,10 |
| Y<br>A | WO 2010/027031 A1 (Fujifilm Corp.),<br>11 March 2010 (11.03.2010),<br>paragraphs [0132], [0136]<br>(Family: none) | 12-23<br>1-11,20-23 |
| A | WO 2011/030055 A1 (UNIVERSITE PAUL SABATIER TOULOUSE III),<br>17 March 2011 (17.03.2011),<br>entire text; all drawings<br>& FR 2949773 A1 | 1-23 |
| A | WO 2010/098369 A1 (Nagoya University),<br>02 September 2010 (02.09.2010),<br>entire text; all drawings<br>& US 2012/0074361 A1 | 1-23 |
| A | S. IKEDA et al., Multicomponent sulfides as narrow gap hydrogen evolution photocatalysts, Physical Chemistry Chemical Physics, 2010.09.20, Vol.12, No.42, p.13943-13949 | 1-23 |
| A | I. TSUJI et al., Novel Stannite-type Complex Sulfide Photocatalysts $A^I_2$-Zn-$A^{IV}$-$S_4$ ($A^I$ = Cu and Ag; $A^{IV}$ = Sn and Ge) for Hydrogen Evolution under Visible-Light Irradiation, Chemistry of Materials, 2010.01.06, Vol.22, No.4, p.1402-1409 | 1-23 |

Form PCT/ISA/210 (continuation of second sheet) (July 2009)

## INTERNATIONAL SEARCH REPORT

| International application No. |
| --- |
| PCT/JP2012/074461 |

**Box No. II        Observations where certain claims were found unsearchable (Continuation of item 2 of first sheet)**

This international search report has not been established in respect of certain claims under Article 17(2)(a) for the following reasons:

1. ☐ Claims Nos.:
   because they relate to subject matter not required to be searched by this Authority, namely:

2. ☐ Claims Nos.:
   because they relate to parts of the international application that do not comply with the prescribed requirements to such an extent that no meaningful international search can be carried out, specifically:

3. ☐ Claims Nos.:
   because they are dependent claims and are not drafted in accordance with the second and third sentences of Rule 6.4(a).

**Box No. III        Observations where unity of invention is lacking (Continuation of item 3 of first sheet)**

This International Searching Authority found multiple inventions in this international application, as follows:
    The following documents 1-3, which are cited in this international search report, disclose the production method defined in claim 1, the invention of claim 1 cannot be considered to be novel in the light of the inventions disclosed in the documents 1-3 and does not have a special technical feature.
    As a result of judging special technical features with respect to claims dependent on claim 1, the inventions of claims 1-5 are classified into main invention and the inventions of other claims are classified into different inventions.
    (Continued to extra sheet)

1. ☐ As all required additional search fees were timely paid by the applicant, this international search report covers all searchable claims.

2. ☒ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant.   Consequently, this international search report is restricted to the invention first mentioned in the claims; it is covered by claims Nos.:

**Remark on Protest**        ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (July 2009)

| INTERNATIONAL SEARCH REPORT | International application No. |
|---|---|
| | PCT/JP2012/074461 |

Continuation of Box No.III of continuation of first sheet(2)

Document 1: KR 10-2011-0075227 A (DAEGU GYEONGBUK INSTITUTE OF SCIENCE AND TECHNOLOGY), 06 July 2011 (06.07.2011)
Document 2: WO 2011/016283 A1 (Mitsui Mining & Smelting Co., Ltd.), 10 February 2011 (10.02.2011)
Document 3: CN 101844797 A (DONGHUA UNIVERSITY), 29 September 2010 (29.09.2010)

Form PCT/ISA/210 (extra sheet) (July 2009)

**REFERENCES CITED IN THE DESCRIPTION**

**Patent documents cited in the description**

- JP 2009026891 A

- US 20110097496 A